# EUROPEAN PATENT SPECIFICATION

(11) **EP 1 804 201 B1**
(45) Date of publication and mention of the grant of the patent: **13.05.2009**
(21) Application number: 05028725.9
(22) Date of filing: 30.12.2005
(51) Int. Cl.: G06K 19/077, B42D 15/10

(54) **Module for an IC card**
Modul einer IC-Karte
Module d'une carte à puce

(43) Date of publication of application: 04.07.2007
(73) Proprietor: Incard SA, 1204 Geneva (CH)
(72) Inventor: Frallicciardi, Paolo, 84100 Salerno (IT); Visconti, Edoardo, 80034 Marigliano (Napoli) (IT)
(74) Representative: Botti, Mario

(56) References cited:
- DE-A1- 10 101 280
- FR-A- 2 634 095
- US-A- 5 834 755
- US-A- 6 076 737
- US-A1- 2003 016 507

## Description

### Filed of application

The present invention relates to a plated module for an IC Card including a printed circuit comprising a plurality of conductive areas, delimited by a network of insulating channels, intended for covering an integrated circuit chip.

More particularly, the present invention relates to a plated module of the type described including a printed circuit comprising a plurality of conductive areas, delimited by a network of insulating channels, for covering an integrated circuit chip intended to be hosted in a recess of a plastic support of an IC card, at least some of the conductive areas being connected to a corresponding contact points of the integrated circuit chip.

### Prior Art

As is well known a plated module is generally formed by two elements:
- an integrated circuit chip,
- a printed circuit over said chip.

Plated modules are known e.g. from US-A-5 834 755.

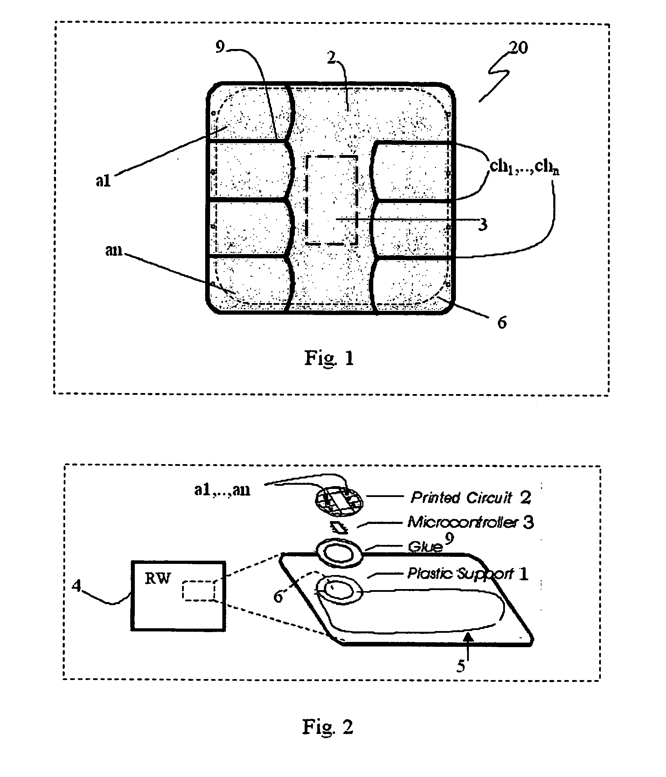

With reference to figure 1, a plated module comprising a printed circuit 2 and an integrated circuit chip 3, is represented and globally indicated with numeral reference 20.

More particularly, the printed circuit 2 comprises a plurality of conductive areas a1,.., an, generally glued through an epoxy resin 9.

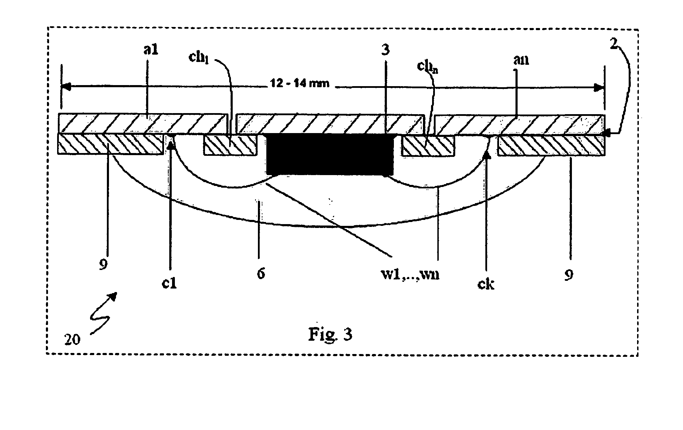

The integrated circuit chip 3 is fixed and electrically connected through wires bonding beneath the printed circuit 2, before being sealed in a recess 6 of a generic plastic support 1, as schematically represented in figure 2. Said electrical connections are clearly shown in figure 1 and 3, representing respectively a top view of the printed circuit 2, sealed inside the recess 6 with the integrated circuit chip 3 beneath, and the corresponding lateral cross section.

A plurality of bond wires w1,..,wn connects some or all of said conductive areas a1,.., ak (if all, n=k) to said integrated circuit chip 3 in a plurality of contact points c1,..,ck. These contact points c1,..,ck provides communication connection between an external read write device 4 and the integrated circuit chip 3.

Generally, the plastic support 1, in which the plated module 20 is hosted, may be kept by the user in wallets or envelopes that might be protective, subject to bending or stressing forces on the plastic support 1 itself.

Therefore, in order to avoid breakage, the integrated circuit chip 3 is restricted to only a few millimeters in size and is protected through the printed circuit 2 from physical pressures and static electricity.

More particularly, to hold the integrated circuit chip 3 assembled with the printed circuit 2, the recess 6 is milled into the plastic support 1 using CNC machines with multiple drill bits, the dimension and location of the recess 6 being carefully controlled to meet with ISO standards.

Nevertheless, being the plastic support 1 usually kept by hand and hidden in wallets, it undergoes to usury and solicitation damages and stress mainly with respect to the printed circuit 2 and the integrated circuit chip 3, especially around the recess 6 wherein they lies.

More particularly, when the plastic support 1 is plated, deformed or stressed, the solicitations act in proximity to the external circumference of the recess 6, sometimes causing the partial detaching of the integrated circuit chip 3 from the plastic support 1.

Even if these solicitations don't cause said detaching, the contact points c1..ck may be damaged, causing the communication between the integrated circuit chip 3 and the corresponding external read write device 4 to fail.

The problem at the basis of the present invention is that of providing a plated module resistant to solicitations due to deforming, especially reducing the effect of these solicitations in proximity of the recess of a plastic support wherein the printed circuit and the integrated circuit chip resides, safeguarding the contact points that connects the conductive areas of the printed circuit to the respective bonding wires.

### Summary of the invention

This problem is solved, according to the present invention, by a plated module as defined in claim 1.

The features and advantages of the invention will be apparent from the following description of an embodiment thereof, given by way of non-limitative example with reference to the accompanying drawings.

### Brief description of the drawings

- Figure 1 schematically represents, in a top view, a plated module realised according to the prior art.
- Figure 2 schematically represents, in a perspective exploded view, a plastic support wherein a plated module resides, realised according to the prior art.
- Figure 3 schematically represents, in a lateral view, the plated module of figure 1.
- Figure 4 schematically represents a plated module realised according to the present invention.
- Figure 5 schematically represents an IC card comprising a plated module realised according to the present invention.

### Detailed description

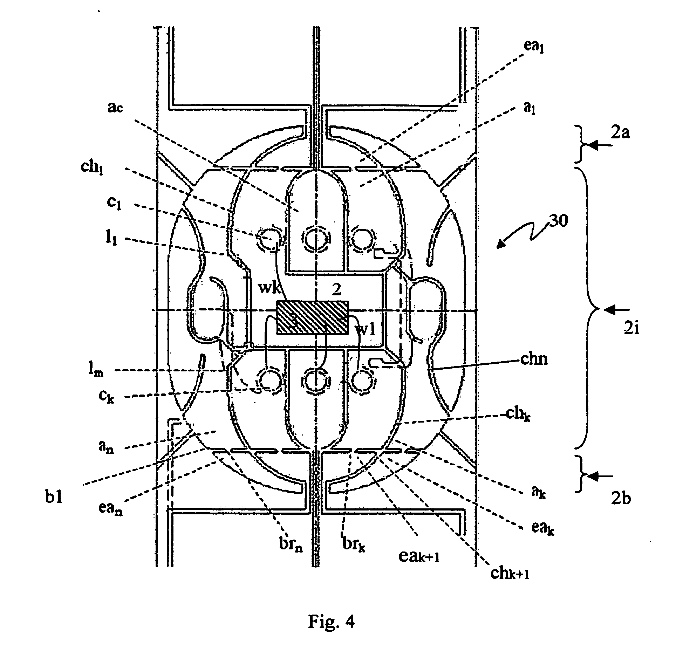

With more specific reference to figure 4 is shown and is globally indicated with 30 a plated module including a printed circuit 2 comprising a plurality of conductive areas a₁,..,aₙ delimited by a network of insulating channels ch₁,..,chₙ, intended for covering an integrated circuit chip 3.

More particularly, at least some of the conductive areas a₁,..,aₙ are connected through wire bonding w₁,..,wₖ to a corresponding contact point c₁,..,cₖ on the integrated circuit chip 3, so to provide communication connection between an external read write device 4 and the integrated circuit chip 3.

According to the present invention, at least some of the conductive areas a₁,..,aₙ bonded to contact points c₁,..,cₖ are linked to a corresponding extended or external area ea₁,..,eaₙ by one or more bridge br₁,.., brₙ.

A plurality of additional insulating channel cₖ₊₁ delimitates an external area eaₖ from a nearby conductive area a₁,..., an or from a nearby external area ea₁,..., eaₖ.

The insulating channels ch₁,..,chₖ surround the conductive areas a₁,..,aₙ bonded to contact points c₁,..,cₖ as a frame, so to protect the connection with the corresponding contact point c₁,..,cₖ.

More particularly, the extended or external areas ea₁,..., eaₖ are composed of the same material used for the corresponding conductive areas a₁,..,aₙ, na₁,..,naₙ.

Also the bridge br₁,.., brₙ may be constituted by the same material used for the conductive areas a₁,..,aₙ, na₁,..,naₙ, rendering easier the working process of the plated module 30 easy.

More particularly, an insulating channel b₁, divides the conductive areas a₁,..,aₙ from the nearby extended or external areas ea₁,..,eaₘ, being the insulating channel b1 crossed by a plurality of bridges br₁,.., brₙ.

The bridges br₁,.., brₙ on the insulating channel b1 act as a mechanical bypass between an internal part (2i), including the conductive areas a₁,..,aₙ and a border parts (2a, 2b), comprising the external areas ea₁,..,eaₘ.

The mechanical bypass is intended to render said border parts (2a, 2b) flexible respect to the internal part (2i), and to absorb solicitations on the plastic support 1, as a flexible wing in favour of the static internal part (2i).

More particularly, the internal part (2i) remains adherent to the recess 6, safeguarding the wire bonding between the conductive areas (a1, ..., an) and the contact points (cl, ..., ck) on the integrated circuit 3.

The plated module 30 has a rounded border formed by, at least, a couple of advanced extended areas Adv₁,Advₙ.

The advanced extended areas Adv₁,..., Advn forming the round border of said plated module 30 are linked to corresponding conductive areas.

These conductive areas are not associated to the integrated circuit chip with corresponding contact points c₁,..., cₖ.

The advanced extended areas forming the round border, circle or wrap around other extended areas ea₁,..., eaₙ, which are associated to conductive areas a₁,..., aₙ linked through said contact points c₁,..., cₖ.

In other words the extended areas ea₁,..,eaₙ and the advanced extended areas form together corresponding border parts 2a, 2b at opposite sides of the core internal part 2i of the module. These border parts 2a, 2b may be considered wings with respect to the core internal part 2i and are linked to such an internal part 2i through the bridges br₁,.., brₙ aligned along the insulating channels b1, b2 thus forming a sort of weakening and separation lines clearly visible in figure 4.

In this way, the solicitations acting on the border of the recess 6 are distributed especially on external area ea₁,..., eaₙ that are passive with respect to the functioning of the integrated circuit 3.

More particularly, both the border parts 2a, 2b of the plated module 30 are rounded by corresponding couple of advanced extended areas

The conductive areas a₁, aₙ have at least a major side that is curved.

They have also a minor side curved, rounding and protecting the connection with the corresponding contact point c₁,..,cₖ. At least one central conductive area a_{c} has a semi-circumferential side.

According to another embodiment of the present invention, the extended areas ea₁,..., eaₙ are formed by a material different from that used for the corresponding conductive area a₁,..., aₙ.

For example, the external areas ea₁,..., eaₙ may be constituted by epoxy resin 9 filling the border parts 2a, 2b and absorbing solicitations acting on the border of the plated module 30.

Moreover, the epoxy resin 9, distributed on the border parts 2a, 2b, increases the adherence of the conductive areas a₁, aₙ on the internal part 2i. Also the bridges br₁, ..., brₖ, are, according to this embodiment, in epoxy resin 9.

According to another embodiment of the present invention, the external areas ea₁,..., eaₙ are formed by a material different from the epoxy resin for example an insulating or conductive material easy coupling with the recess 6 and resistant to solicitations and pressures.

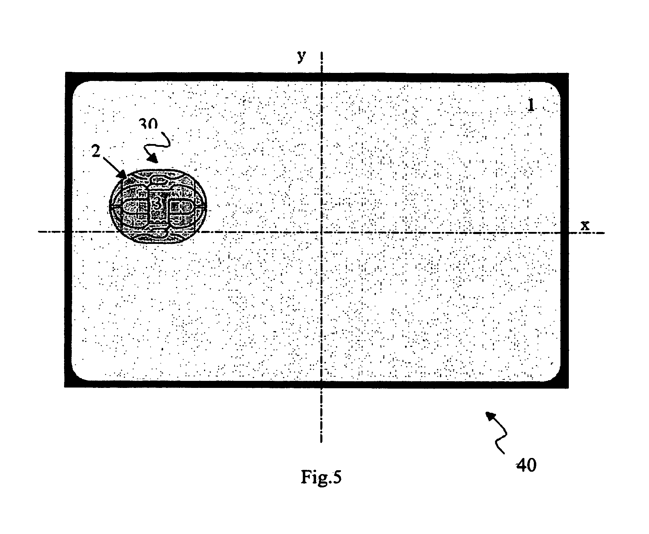

The present invention also relates to an IC Card comprising a plated module. With specific reference to figure 5 is shown and is globally indicated with 40 an IC Card comprising a plated module 30 including a printed circuit 2 with a plurality of conductive areas a₁,..,aₙ, delimited by a network of insulating channels ch₁,..,chₙ, intended for covering an integrated circuit chip 3.

More particularly the IC card (40) also comprises a plastic support 1 with a recess 6, an integrated circuit chip 3, the plated module 30 covering the integrated circuit chip (3).

A major surface of the plastic support 1 has a major axis x and a minor axis y of a major. Advantageously, the recess 6 on the plastic support 1 of the IC Card 40 is decentered respect the major axis x and/or the minor axis y of the plastic support 1.

More particularly, the x and y axis delimitates a quadrant q of the major surface of the plastic support 1. Advantageously, the recess 6 of the IC Card 40 is inside the quadrant q of the major surface of the plastic support 1.

The plated module 30 according to the present invention is resistant to solicitations due to bending or deforming, especially reducing the effect of these solicitations in proximity of the recess 6 of the plastic support 1 wherein the printed circuit 2 and the integrated circuit chip 3 resides.

The plurality of extended areas in fact, absorb solicitations near the border of recess 6 and protects the contact points cl..ck that connects the conductive areas a1,..,an of the printed circuit 1 to the respective bonding wires w1,..,wn.

A possible break of an extended area ea₁,..., eaₙ, its detachment from the recess 6 or a dissociation with a corresponding conductive area does not cause the in utilization of the plated support 30. The concentric disposition of the advanced extended areas ea₁,..., eaₙ as a protection of the extended areas ea₁,..., eaₙ linked to conductive areas directly associated to the integrated circuit chip 3, preserve the functioning of the integrated circuit chip 3.

## Claims

1. Plated module (20) for an IC card comprising
a printed circuit (2) and an integrated circuit chip (3),
the printed circuit comprising a plurality of conductive areas (a1,..,an) delimited by a network of insulating channels (ch1,..,chk),
the plated module being suitable for covering the integrated circuit chip (3) which can be hosted in a recess (6) of a plastic support (1) of said IC card,
whereby some of said conductive areas (a1,..,an) are connected to corresponding contact points (c1,..,cj) of said integrated circuit chip (3),
and at least some of said conductive areas (a1,..,an) are linked to a corresponding extended area by one or more bridges (br1,.., brl)
**characterised by**
the printed circuit further comprising advanced extended areas which are linked to those conductive areas which are not connected with contact points of said integrated circuit
whereby the advanced extended areas circle or wrap around those extended areas which are linked to those conductive areas which are connected to said contact points (c1 ... ck) of said integrated circuit
and whereby the advanced extended areas form rounded opposite sides of said plated module.

2. Plated module (20) according to claim 1 **characterised by** the fact that said extended areas (ea₁,..,eaₘ) and/or said bridges (br₁,.., br₁) are conductive.

3. Plated module (20) according to claim 1 **characterised by** the fact that said conductive areas (a₁,..,aₙ) which are connected to the contact points (c₁,..,cₖ) are separated from said extended areas (ea₁,..,eaₘ) and said advanced extended areas by insulating channels (b₁, b₂), crossed by said bridges (br₁,.., brₗ).

4. Plated module (20) according to claims 1 or 2 **characterised by** the fact that rounded insulating channels (ch₁,..,chₖ) surround said conductive areas (a₁,..,aₙ) which are connected to the contact points (c₁,..,cₖ) as a protection frame for said contact points (c₁,..,cₖ).

5. Plated module (20) according to claim 4 **characterised by** the fact that at least a major side of at least one of said conductive areas (a₁, aₙ) is curved.

6. Plated module (20) according to claim 1 **characterised by** the fact that at least one central conductive area (a_{c}) of said conductive areas (a₁,..,aₙ) has a semi-circumferential side.

7. Plated module (20) according to claim 1 **characterised by** the fact that said extended areas (ea₁,..,eaₘ) and/or said bridges (br₁,.., br^{l}) are in insulating material.

8. IC Card comprising:
- a plated module (20),
- a plastic support (1) with a recess (6)
- an integrated circuit chip (3),
said plated module (20) covering said integrated circuit chip (3) **characterised by** the fact that said plated module is structured according one of the previous claim 1-7.

9. IC Card according to claim 8 **characterised by** the fact that said recess (6) is decentered respect a major axis (x) and/or a minor axis (y) of a major surface of said plastic support (1).

10. IC Card according to claim 9 **characterised by** the fact that said recess (6) is inside a quadrant (q) of the major surface of said plastic support (1) delimited by said major and minor axis (x, y).

## Patentansprüche

1. Plattiertes Modul (20) für eine IC-Karte, aufweisend
eine gedruckte Schaltung (2) und einen Chip mit integrierter Schaltung (3), wobei die gedruckte Schaltung eine Mehrzahl von leitfähigen Bereichen (a1,...,an) aufweist, die durch ein Netzwerk von isolierenden Kanälen (ch1,...,chk) begrenzt sind,
wobei das plattierte Modul dafür geeignet ist, den Chip mit der integrierten Schaltung (3), der in einer Ausnehmung (6) eines Kunststoffträgers (1) der IC-Karte untergebracht sein kann, abzudecken,
wobei einige der leitfähigen Bereiche (a1,...,an) mit entsprechenden Kontaktpunkten (c1,...,cj) des Chips mit integrierter Schaltung (3) verbunden sind
und mindestens einige der leitfähigen Bereiche (a1,...,an) über eine oder mehrere Brücken (br1,..., brl) mit einem entsprechenden erweiterten Bereich verbunden sind,
**dadurch gekennzeichnet, dass**
die gedruckte Schaltung ferner weitergehende erweiterte Bereiche aufweist, die mit den leitfähigen Bereichen verbunden sind, die nicht mit Kontaktpunkten der integrierten Schaltung verbunden sind,
wobei die weitergehenden erweiterten Bereiche die erweiterten Bereiche umrunden oder umgeben, die mit den leitfähigen Bereichen verbunden sind, die mit den Kontaktpunkten (c1,...,ck) der integrierten Schaltung verbunden sind,
und wobei die weitergehenden erweiterten Bereiche gerundete gegenüberliegende Seiten des plattierten Moduls bilden.

2. Plattiertes Modul (20) nach Anspruch 1, **gekennzeichnet durch** die Tatsache, dass die erweiterten Bereiche (ea₁,...,eaₘ) und/oder die Brücken (br₁,...,brₗ) leitfähig sind.

3. Plattiertes Modul (20) nach Anspruch 1, **gekennzeichnet durch** die Tatsache, dass die mit den Kontaktpunkten (c₁,...,cₖ) verbundenen leitfähigen Bereiche (a₁,...,aₙ) von den erweiterten Bereichen (ea₁,...,eaₘ) und den weitergehenden erweiterten Bereichen **durch** isolierende Kanäle (b₁, b₂) getrennt sind, die von den Brücken (br₁,...,brₗ) überquert werden.

4. Plattiertes Modul (20) nach Anspruch 1 oder 2, **gekennzeichnet durch** die Tatsache, dass gerundete isolierende Kanäle (ch₁,...,chₖ) die mit den Kontaktpunkten (c₁,...,cₖ) verbundenen leitfähigen Bereiche (a₁,...,aₙ) als ein Schutzrahmen für die Kontaktpunkte (c₁,...,cₖ) umgeben.

5. Plattiertes Modul (20) nach Anspruch 4, **gekennzeichnet durch** die Tatsache, dass mindestens eine Hauptseite mindestens eines der leitfähigen Bereiche (a₁, aₙ) kurvenförmig ist.

6. Plattiertes Modul (20) nach Anspruch 1, **gekennzeichnet durch** die Tatsache, dass mindestens ein in der Mitte gelegener leitfähiger Bereich (a_{c}) der leitfähigen Bereiche (a₁,...,aₙ) eine halbkreisförmige Seite hat.

7. Plattiertes Modul (20) nach Anspruch 1, **gekennzeichnet durch** die Tatsache, dass die erweiterten Bereiche (ea₁,...,eaₘ) und/oder die Brücken (br₁,...,brₗ) in isolierendem Material sind.

8. IC-Karte, aufweisend:
- ein plattiertes Modul (20),
- einen Kunsttoffträger (1) mit einer Ausnehmung (6),
- einen Chip mit integrierter Schaltung (3),
wobei das plattierte Modul (20) den Chip mit integrierter Schaltung (3) abdeckt, **gekennzeichnet durch** die Tatsache, dass das plattierte Modul gemäß einem der vorhergehenden Ansprüche 1-7 strukturiert ist.

9. IC-Karte nach Anspruch 8, **gekennzeichnet durch** die Tatsache, dass die Ausnehmung (6) bezüglich einer Hauptachse (x) und/oder einer Nebenachse (y) einer Hauptoberfläche des Kunststoffträgers (1) dezentriert ist.

10. IC-Karte nach Anspruch 9, **gekennzeichnet durch** die Tatsache, dass sich die Ausnehmung (6) innerhalb eines Quadranten (q) der Hauptoberfläche des Kunststoffträgers (1) befindet, der von der Haupt- und der Nebenachse (x, y) begrenzt ist.

## Revendications

1. Module plaqué (20) pour une carte à puce comprenant :
un circuit imprimé (2) et une puce de circuit intégré (3),
le circuit imprimé comprenant une pluralité de zones conductrices (a1,..., an) délimitées par un réseau de canaux isolants (ch1,...,chk),
le module plaqué étant adapté pour couvrir la puce de circuit intégré (3) qui peut être logée dans un évidement (6) d'un support en plastique (1) de ladite carte à puce,
moyennant quoi certaines desdites zones conductrices (a1,..., an) sont connectées à des points de contact correspondants (c1,..., cj) de ladite puce de circuit intégré (3),
et au moins certaines desdites zones conductrices (a1,..., an) sont reliées à une zone étendue correspondante par un ou plusieurs ponts (br1,..., bri),
**caractérisé en ce que** le circuit imprimé comprend en outre des zones étendues avancées qui sont reliées aux zones conductrices qui ne sont pas connectées à des points de contact dudit circuit intégré,
moyennant quoi les zones étendues avancées encerclent ou s'enroulent autour des zones étendues qui sont reliées aux zones conductrices qui sont connectées auxdits points de contact (c1,..., ck) dudit circuit intégré,
et dans lequel les zones étendues avancées forment des côtés opposés arrondis dudit module plaqué.

2. Module plaqué (20) selon la revendication 1, **caractérisé par le fait que** lesdites zones étendues (ea₁,..., eaₘ) et/ou lesdits ponts (br₁,..., brᵢ) sont conducteurs.

3. Module plaqué (20) selon la revendication 1, **caractérisé par le fait que** lesdites zones conductrices (a₁,..., aₙ) qui sont connectées aux points de contact (c₁,..., cₖ) sont séparées desdites zones étendues (ea₁,..., eaₘ) et desdites zones étendues avancées par des canaux isolants (b₁, b₂), qui croisent lesdits ponts (br₁,..., brᵢ).

4. Module plaqué (20) selon la revendication 1 ou 2, **caractérisé par le fait que** des canaux isolants arrondis (ch₁,..., chₖ) entourent lesdites zones conductrices (a₁,..., aₙ) qui sont connectées aux points de contact (c₁,.... cₖ) pour former un cadre de protection pour lesdits points de contact (c₁,..., cₖ).

5. Module plaqué (20) selon la revendication 4, **caractérisé par le fait qu'**au moins un grand côté d'au moins l'une des zones conductrices (a₁, aₙ) est courbé.

6. Module plaqué (20) selon la revendication 1, **caractérisé par le fait qu'**au moins une zone conductrice centrale (a_{c}) desdites zones conductrices (a₁,..., aₙ) a un côté semi-périphérique.

7. Module plaqué (20) selon la revendication 1, **caractérisé par le fait que** lesdites zones étendues (ea₁,..., eaₘ) et/ou lesdits ponts (br₁,..., brᵢ) sont en matériau isolant.

8. Carte à puce comprenant :
- un module plaqué (20),
- un support en plastique (1) comportant un évidement (6),
- une puce de circuit intégré (3),
ledit module plaqué (20) couvrant ladite puce de circuit intégré (3), **caractérisée par le fait que** ledit module plaqué est structuré selon l'une des précédentes revendications 1 à 7.

9. Carte à puce selon la revendication 8, **caractérisée par le fait que** ledit évidement (6) est décentré par rapport à un grand axe (x) et/ou un petit axe (y) d'une surface principale dudit support en plastique (1).

10. Carte à puce selon la revendication 9, **caractérisée par le fait que** ledit évidement (6) se trouve à l'intérieur d'un quadrant (q) de la surface principale dudit support en plastique (1) délimité par lesdits grand et petit axes (x, y).
